# FASCICULE DE BREVET EUROPEEN

(11) **EP 2 089 787 B1**
(45) Date de publication et mention de la délivrance du brevet: **23.03.2011**
(21) Numéro de dépôt: 07822054.8
(22) Date de dépôt: 30.10.2007
(51) Int. Cl.: G06F 1/20, H04N 5/44, H05K 7/20

(54) **PROCEDE DE TELECHARGEMENT DE PARAMETRES D'UTILISATION DANS UN APPAREIL, ET APPAREIL POUR LA MISE EN OEUVRE DE L'INVENTION**
VERFAHREN ZUM HERUNTERLADEN VON BENUTZUNGSPARAMETERN IN EINE VORRICHTUNG UND VORRICHTUNG ZUR IMPLEMENTIERUNG DER ERFINDUNG
METHOD OF DOWNLOADING USAGE PARAMETERS INTO AN APPARATUS, AND APPARATUS FOR IMPLEMENTING THE INVENTION

(30) Priorité: 09.11.2006 FR 0654809
(43) Date de publication de la demande: 19.08.2009
(73) Titulaire: Thomson Licensing, 92130 Issy-les-Moulineaux (FR)
(72) Inventeur: MACE, Philippe, 35000 Rennes (FR); ROUX, Luc, 44530 Severac (FR); MAZZANTE, Angelo, 35520 Melesse (FR)
(74) Mandataire: Benezeth, Philippe J.L. M.
(86) Numéro de dépôt international: PCT/EP2007/061702
(87) Numéro de publication internationale: WO 2008/055822

(56) Documents cités:
- WO-A-2004/109885
- FR-A- 2 816 078
- US-A1- 5 761 085
- US-A1- 2003 011 984
- US-B1- 6 390 379

## Description

La présente invention concerne un procédé de téléchargement de paramètres d'utilisation dans un appareil, et un appareil pour la mise en oeuvre de l'invention.

De nos jours, de nombreux appareils permettent la réception et la reproduction d'oeuvres audiovisuelles enregistrées. Récemment, des disques durs de grande capacité ont été intégrés à ces récepteurs audiovisuels ; on peut y stocker des contenus téléchargés soit d'un réseau de diffusion unidirectionnel, soit d'un réseau point à point (Internet par exemple). Les appareils disposent d'équipements performants permettant de répondre parfaitement aux besoins de l'utilisateur. Cette souplesse d'utilisation résulte de programmes exécutables capables d'analyser le comportement de l'utilisateur. Par exemple, lorsqu'un utilisateur sélectionne souvent certaines chaînes de télévision, le récepteur peut les rassembler dans une liste de chaînes favorites, et ainsi permettre à cet utilisateur d'accéder plus facilement à ces chaînes.

Sur le plan matériel, les appareils électriques consomment une importante énergie. Cette énergie se transforme en chaleur qui se concentre à l'intérieur. Si elle n'est pas évacuée cette chaleur provoque un vieillissement accéléré des composants électroniques finissant par une détérioration irréversible. Pour éviter cela, les constructeurs découpent dans le boîtier de l'appareil des ouïes d'aération permettant une évacuation de l'air chaud. Un ventilateur est disposé à proximité des ouïes pour accélérer les échanges avec l'extérieur et améliorer le refroidissement. Mais l'utilisation à pleine vitesse d'un ventilateur est bruyante, de sorte que les constructeurs d'appareil ont mis en place un système d'asservissement qui module la commande en fonction d'une mesure de température. De cette façon, le ventilateur tourne à une vitesse juste suffisante pour assurer un bon refroidissement avec un niveau sonore minimum. Le système d'asservissement est un programme standard qu'il convient d'adapter à chaque appareil. Cette adaptation peut s'effectuer en laboratoire, pour cela le technicien allume l'appareil, analyse son fonctionnement par des appareils de mesure et définit des paramètres d'utilisation. Mais ces réglages sont effectués sur un matériel neuf et dans des conditions particulières qui ne sont pas forcément adaptées à l'endroit où l'appareil va finalement être utilisé. De plus, ces paramètres peuvent évoluer après un certain temps d'utilisation. C'est pourquoi les constructeurs ont doté les appareils d'une fonction d'auto apprentissage. Dans un premier temps, l'appareil utilise les paramètres par défaut définis en laboratoire. Puis, en analysant son fonctionnement l'appareil modifie ces paramètres afin d'en améliorer son fonctionnement. Lors des mises sous tension ultérieures, ce sont de nouveaux paramètres qui seront utilisés.

La fonction d'auto apprentissage permet d'élaborer des paramètres optimaux d'utilisation, mais elle nécessite que chaque appareil effectue son propre auto apprentissage. Au cours de l'étape d'auto apprentissage, la valeur des paramètres s'affine afin de devenir optimale. La présente invention permet notamment de réduire le temps pour qu'un appareil possède des paramètres dont les valeurs sont optimales.

Le document WO 2004/109885 déposé par la société SIEMENS décrit un fusible électronique qui se déclenche suite à une consigne dépendant d'une valeur de référence fournie par une étape d'auto-apprentissage. L'étape d'auto-apprentissage consiste à analyser la tension pendant une fenêtre temporelle donnée, les valeurs ainsi mesurées sont mémorisées et analysées. Puis, une référence est fixée et transférée grâce à un réseau de communication vers d'autres systèmes utilisant des fusibles électroniques. Ce document enseigne l'élaboration de paramètres au cours d'une longue période d'utilisation, mais n'apporte pas de solution pour des paramètres mis au point au cours d'une succession de plusieurs mises en marche.

Le document US 5 761 085 déposé par GIORGIO PAUL décrit un réseau permettant de gérer des paramètres variables entre plusieurs appareils. Il est possible de transmettre à un autre appareil, par exemple un paramètre de commande du ventilateur, pour que celui-ci ne fasse pas trop de bruit. Selon ce document, le paramètre est demandé par l'autre appareil afin de faire un contrôle de valeur et ainsi permettre de détecter des pannes. De ce fait, le paramètre ne peut servir utilement à d'autres appareils.

Un des objets de la présente invention est un procédé de téléchargement de paramètres d'utilisation, le procédé comporte une étape d'auto apprentissage exécutée lors d'une pluralité de mises en marche en vue d'élaborer de nouveaux paramètres d'utilisation à partir de premiers paramètres d'utilisation utilisés lors de la première mise sous tension d'un premier appareil, l'étape d'auto apprentissage étant exécutée au niveau du premier appareil le procédé est caractérisé en ce qu'il comporte en outre :
- à l'issue de la pluralité de mises en marche permettant d'élaborer de nouveaux paramètres d'utilisation et lorsque leur variation d'une mise en marche à la mise en marche suivante et inférieure à un ratio déterminé, une étape de transmission des nouveaux paramètres d'utilisation du premier appareil vers un au moins un second appareil,
- une étape d'utilisation des nouveaux paramètres d'utilisation téléchargés dans le second appareil en remplacement de ceux en cours d'élaboration lors d'une étape d'auto apprentissage exécutée au niveau dudit second appareil.

De cette façon, les nouveaux paramètres mis au point par un premier appareil peuvent servir à un second appareil, ce second appareil n'ayant pas besoin de mener à bien une étape complète d'auto apprentissage. De cette manière, le second appareil utilise de nouveaux paramètres juste après le téléchargement. Ainsi, les nouveaux paramètres sont obtenus plus vite au niveau des seconds appareils. De tels paramètres peuvent servir à programmer la mise en route d'un ventilateur, ou le partitionnement de la mémoire de travail.

Selon un perfectionnement, les paramètres d'utilisation provenant de premiers appareils sont transmis à un serveur, celui-ci les transmettant à au moins un second appareil en réponse à une requête de ce dernier. De cette façon, l'appareil centralise les paramètres reçus et les transmet à ceux qui en font la demande. Selon un autre perfectionnement, le serveur modifie les paramètres reçus avant de les envoyer à au moins un second appareil. La modification des paramètres consiste à effectuer la moyenne des valeurs reçues ou à rajouter une valeur déterminée aux valeurs reçues. De cette façon, le serveur peut déterminer des valeurs moyennes ou ajouter une marge de sécurité avant de transmettre les paramètres aux appareils qui en font la demande. Selon un autre perfectionnement, le serveur diffuse les paramètres sur un réseau unidirectionnel. De cette façon, les seconds appareils n'ont pas besoin de les demander, ni d'établir une liaison point à point entre eux et le serveur.

Un autre objet de la présente invention est un appareil électronique, tel que défini dans la revendication indépendante 6, comportant un moyen d'élaboration de nouveaux paramètres d'utilisation au cours d'un auto apprentissage.

D'autres caractéristiques et avantages de la présente invention ressortiront de la description des exemples de réalisation qui vont suivre, pris à titre d'exemples non limitatifs, en référence aux figures annexées dans lesquelles :
La figure 1 est un diagramme bloc d'un récepteur audiovisuel pour la mise en oeuvre de l'invention,
La figure 2 est un schéma montrant les différents éléments d'un serveur,
La figure 3 est un schéma d'un exemple de système d'asservissement utilisant la présente invention,
La figure 4 montre les principales étapes du procédé selon un exemple de réalisation,
La figure 5 montre un organigramme détaillé des étapes du procédé selon un exemple de réalisation.

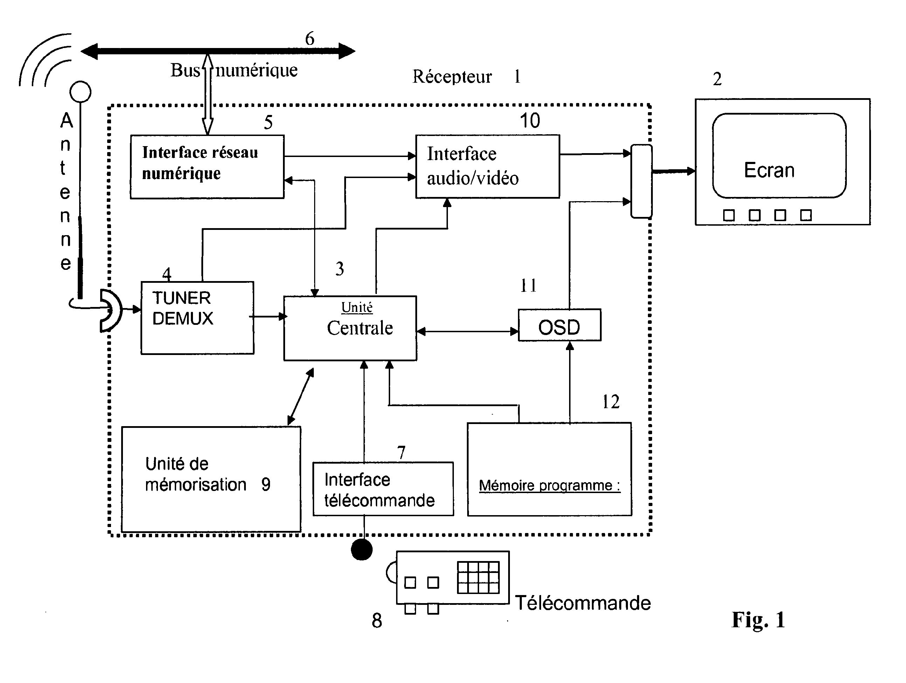

On décrira tout d'abord le fonctionnement d'un récepteur audiovisuel 1 muni d'un dispositif d'affichage 2. Le récepteur comprend une unité centrale 3 reliée à une mémoire de programme 12, et une interface 5 pour la communication avec un bus numérique local à haut débit 6 permettant de transmettre des données audio/vidéo en temps réel. Ce réseau est par exemple un réseau IEEE 1394 ou un bus USB permettant de communiquer avec un ordinateur. Le récepteur 1 peut également recevoir des données analogiques et/ou numériques, par exemple des images ou des informations de service, d'un réseau de diffusion à travers une antenne de réception associée à un démodulateur 4. Le récepteur comprend en outre un récepteur de signaux infrarouges 7 pour recevoir les signaux d'une télécommande 8, une mémoire 9 pour le stockage des données téléchargées, et une logique de décodage audio/vidéo 10 pour la génération des signaux audiovisuels envoyés à l'écran de télévision 2. Selon un exemple de réalisation, la mémoire 9 est un disque dur de grande capacité permettant d'enregistrer des documents audiovisuels. Le récepteur comprend également un circuit 11 d'affichage de données sur l'écran, appelé souvent circuit OSD, de l'Anglais "On Screen Display" (signifiant littéralement "affichage sur l'écran"). Le circuit OSD 11 est un générateur de texte et de graphisme qui permet d'afficher à l'écran des menus, des pictogrammes (par exemple, un numéro correspondant à la chaîne visualisée) et qui permet d'afficher les menus de configuration. Le bus numérique 6 et/ou le réseau de diffusion transmettent au récepteur 1 de données telles que des documents audiovisuels, des données descriptives ou encore des données d'utilisation du récepteur 1. A la mise sous tension, le programme enregistré dans la mémoire 12 est exécuté et initialise l'ensemble des circuits du récepteur, puis les applications de haut niveau sont chargées et prennent la main. L'ensemble des circuits consomment beaucoup d'énergie et dégagent de la chaleur, par exemple, l'unité centrale du récepteur libère une énergie d'environ 6 watts. De ce fait, le récepteur est doté d'un ventilateur (non représenté dans la figure 1) et d'ouïes découpées dans la coque du récepteur pour assurer un flux constant d'air.

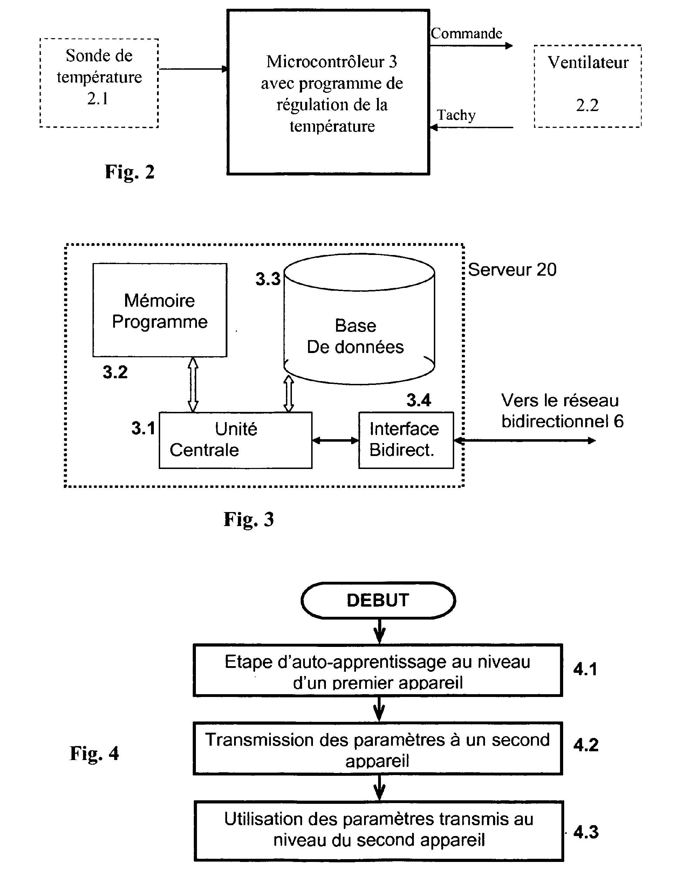

La figure 2 illustre un système d'asservissement selon un exemple préféré de réalisation. Cette figure est applicable à tout système de régulation qui, recevant une valeur de mesure et en fonction d'une valeur de consigne, détermine une valeur de commande. Une sonde de température 2.1 et un ventilateur 2.2 sont connectés à l'unité centrale 3. Ce composant dispose au moins d'une entrée analogique pour la réception des signaux provenant de la sonde de température 2.1, d'une entrée numérique pour la réception des signaux représentatifs de la vitesse du ventilateur 2.2 (ces signaux sont généralement appelés « Tachy ») et d'une sortie de commande pour le contrôle de ce ventilateur 2.2. En fonction de la mesure fournie par la sonde 2.1, l'unité centrale 3 calcule la vitesse du ventilateur pour créer un flux d'air frais pour maintenir l'intérieur du récepteur 1 en dessous d'une température nominale. Selon un exemple préféré de réalisation, le ventilateur est commandé par un signal analogique de type PWM (acronyme de « Pulse Width Modulator ». Un signal PWM est un signal numérique périodique qui, converti en un signal analogique en utilisant un filtre passe bas permet de contrôler la vitesse de rotation du ventilateur. La fréquence du signal est fixe, l'unité centrale 3 fait varier le rapport cyclique. Cette variation de rapport cyclique permet de faire varier l'amplitude du signal analogique de commande du moteur. Dans l'exemple de réalisation, le rapport cyclique du PWM est codé sur 8 bits ce qui correspond à une valeur comprises entre 0 et 255. L'expérimentation a montré que la plage de commande du moteur, sur cette échelle de PWM varie de 120 à 180. Une variation de 1 unité de PWM n'est donc pas négligeable, ce qui explique qu'une telle variation puisse être entendue. La tension continue analogique appliquée varie typiquement entre 0 et 12 Volts. Le signal Tachy est impulsionnel, le nombre d'impulsions par unité de temps détermine la vitesse réelle du ventilateur.

Il existe une étroite corrélation entre les décibels émis par le ventilateur et sa vitesse. Cette valeur de vitesse est un paramètre intermédiaire car la commande effectivement envoyée au ventilateur est fonction du système d'asservissement. Cette valeur de vitesse est à l'origine du volume sonore mesuré. Pour une certaine vitesse le bruit semble bien maîtrisé, si on s'écarte de cette vitesse, le bruit est modifié de façon sensible. Une régulation contrôlant directement le moteur en fonction de la température pourrait assurer une température constante, mais les variations de vitesse seraient acoustiquement perceptibles, et dans certain cas, la commande devrait être maximale ce qui déclencherait un fonctionnement continu bruyant. De ce fait, la commande du ventilateur s'effectue par un système d'asservissement sur la vitesse faisant intervenir différentes plages de température. Chaque plage est associée à une consigne de vitesse constante. Ces plages sont choisies pour que la consigne de vitesse ne soit modifiée que peu souvent.

En fonction de la température mesurée dans l'appareil, une vitesse de rotation est déterminée par l'unité centrale 3. La détermination de la vitesse de consigne s'effectue en fonction de plages de température. Le système de régulation mesure la vitesse actuelle du ventilateur pour déterminer l'écart par rapport à la vitesse de consigne. L'unité centrale 3 fait varier la tension appliquée au moteur pour approcher la vitesse de consigne. Pour ce faire on définit une fonction qui détermine la nouvelle valeur de commande V en fonction de l'écart. Cette fonction utilise une régulation de type PID (Proportionnel, Intégral, Différentiel) qui utilise trois termes visant à assurer une régulation optimale. Le terme proportionnel permet d'arriver rapidement à la valeur de consigne. Le terme intégral permet de compenser une erreur résiduelle. Le terme différentiel évite ou diminue les oscillations intervenant lorsqu'à cause de l'inertie du système, la valeur mesurée dépasse la consigne à atteindre. Les coefficients K_{P}, K_{I} et K_{D} de chaque terme sont calculés par auto apprentissage en analysant les mesures effectuées par la sonde.

Le récepteur 1 peut communiquer à travers le bus numérique 6 avec un serveur 20 dont un mode préféré de réalisation est décrit à la figure 3. Le serveur 20 comporte une unité centrale 3.1, une mémoire 3.2, une logique de formatage des données d'utilisation 3.3 pour télécharger lesdites données et une interface de communication réalisant une pluralité de liaison bidirectionnelle 3.4 à travers le réseau 6 avec les récepteurs décrits précédemment. La mémoire 3.2 contient le programme exécutable et des données d'utilisation d'au moins un récepteur 1 communiquant via le réseau 6.

Après avoir décrit les différents éléments de l'invention, nous allons maintenant expliquer comment ceux-ci coopèrent, par un exemple de réalisation.

Un schéma de principe illustrant un exemple de réalisation du procédé de téléchargement est donné à la figure 4. Dans un premier temps (étape 4.1), un premier appareil exécute une étape d'auto apprentissage. Ce premier appareil met au point un certain nombre de paramètres d'utilisation lors d'une pluralité de mises en marche en vue d'élaborer des paramètres permettant une utilisation optimale d'une fonction au moins de l'appareil. A l'étape 4.2, une fois ces paramètres d'utilisation élaborés, ils sont transmis à un second appareil. A l'étape 4.3, ce second appareil utilise ces paramètres en lieu et place de ses propres paramètres d'utilisation en cours d'élaboration. De cette façon, le second appareil bénéficie de l'apprentissage du premier et possède plus rapidement des paramètres d'utilisation performants. Dans ce schéma simple de réalisation, la liaison entre les premiers appareils et les seconds est directe, réalisé par un port USB par exemple. Dans ce cas, il n'y a pas besoin d'un serveur s'intercalant entre les appareils.

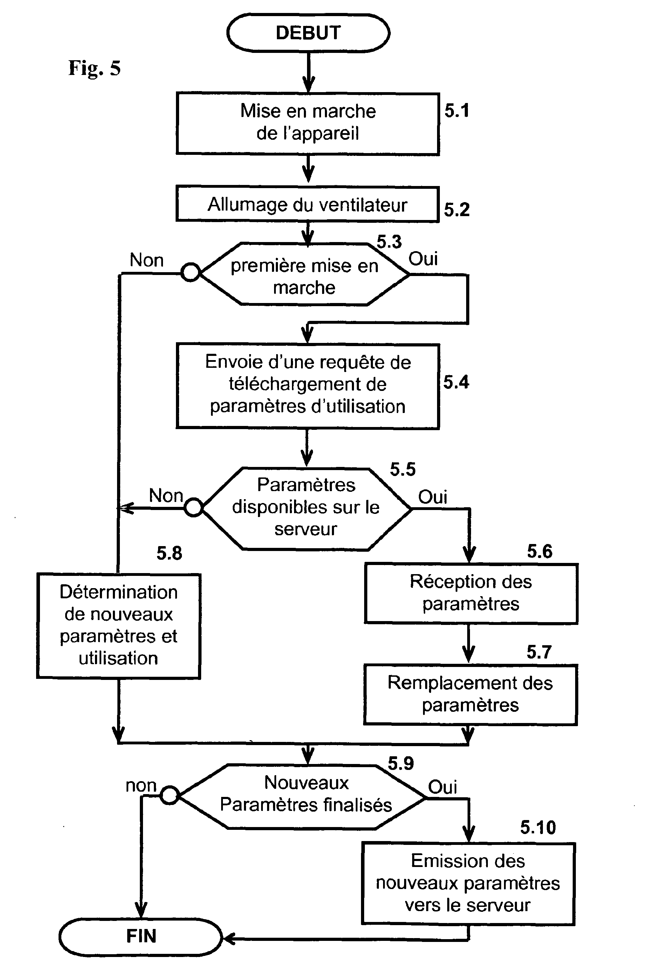

Un schéma plus détaillé d'un exemple de réalisation est présenté par l'organigramme de la figure 5. Cet exemple est appliqué aux paramètres d'allumage du ventilateur. Dans un premier temps (étape 5.1), le récepteur 1 est mis en marche, aussitôt le système d'asservissement allume le ventilateur en utilisant les paramètres par défaut définis en laboratoire (étape 5.2). Ces paramètres sont :
- une valeur de consigne déduite de la valeur donnée actuellement par la sonde de température, ou selon une variante une fourchette établissant une valeur minimale et maximale de consigne,
- un jeu de coefficients K_{P}, K_{D} et K_{I} pour chaque terme de la régulation PID
- une valeur de pas définissant l'écart sur la consigne entre une mise sous tension et la suivante permettant de déterminer la meilleure valeur pour que le ventilateur atteigne sa vitesse nominale.

Puis à l'étape 5.3, le récepteur 1 teste si c'est une première mise en marche. Si c'est le cas, le récepteur a intérêt à demander au serveur de lui envoyer des paramètres élaborés. Le récepteur 1 envoie alors une demande de téléchargement de paramètres d'utilisation au serveur 20 via le réseau numérique 6 (étape 5.4). A l'étape 5.5, le serveur teste si ces paramètres sont disponibles, c'est-à-dire si auparavant un autre récepteur lui a transmis des paramètres élaborés. Si ces données sont disponibles, le serveur les transmet au récepteur 1 (étape 5.6). Une fois les données reçues, le récepteur les mémorise et s'en servira comme nouveaux paramètres lors de la prochaine mise sous tension (étape 5.7). Si le serveur répond que les données ne sont pas disponibles, alors le récepteur doit appliquer une étape d'auto apprentissage pour se calculer lui-même des paramètres d'utilisation (étape 5.8). Selon un exemple simple de réalisation illustré par la figure 5, le récepteur 1 demande au serveur les données d'utilisation à la première mise sous tension. Un perfectionnement consiste en ce que tant que les paramètres d'utilisation ne sont pas optimums, le récepteur demande au serveur si des paramètres d'utilisation sont disponibles. De cette façon, si des paramètres sont téléchargés, la durée de l'étape d'auto apprentissage est réduite.

Au cours de l'étape d'auto apprentissage, le système d'asservissement analyse les mesures effectuées lors de la mise en marche du ventilateur, détermine les écarts avec la valeur prévue et définit éventuellement une nouvelle valeur de consigne et un ajustement des coefficients K_{P}, K_{D} et K_{I}. A la prochaine mise sous tension, ce sont ces nouvelles valeurs qui seront prises en compte.

On voit donc que si des données d'utilisation sont transmises, le récepteur 1 ne tient pas compte des mesures effectuées lors de la première mise sous tension. En effet, l'élaboration de nouveaux paramètres d'utilisation nécessite plusieurs mises sous tension. De ce fait, le fait d'utiliser lors de la seconde mise sous tension des paramètres fournis par un serveur et présumés optimaux, évite l'utilisation de paramètres qui ne sont pas finement établis.

L'utilisation de paramètres téléchargés n'affranchit pas le récepteur du contrôle de leurs utilisations. Dans le cas du ventilateur, les caractéristiques mécaniques peuvent évoluer dans le temps, il est donc nécessaire de vérifier continuellement son fonctionnement, et notamment à l'allumage et éventuellement de corriger les paramètres utilisés lors des allumages ultérieurs. Au bout d'un certain temps d'utilisation, les valeurs des nouveaux paramètres divergent fortement d'un appareil à l'autre à cause du vieillissement, il n'est alors pas souhaitable de les communiquer au serveur qui risquerait de les transmettre à un appareil tout neuf.

Supposons que plusieurs mises sous tension aient été effectuées sans que le récepteur 1 ait reçu des paramètres d'utilisation, soit du réseau bidirectionnel 6, soit du réseau de diffusion. Dans ce cas, le récepteur 1 a eu le temps d'élaborer des paramètres optimaux d'utilisation, à l'aide du système d'asservissement.

La commande du ventilateur est typiquement réalisée par une sortie PWM modulée selon une valeur de 8 bits fournie par l'unité centrale 3. Les tests ont montré que la commande peut varier de 115 à 255, et que pour garantir un démarrage à la mise sous tension, il faut appliquer pendant une durée courte, environ la valeur de 170. Cette valeur permet de lancer le ventilateur mais ce dernier va très vite être bruyant, de sorte qu'après une durée de 1 à 5 secondes, le système d'asservissement va baisser la commande à une valeur comprise entre 130 et 140. Le système d'asservissement, analyse l'augmentation de la vitesse du ventilateur et va commencer à baisser la valeur de commande au démarrage. Généralement, au bout de une à cinq secondes après la mise sous tension, la valeur appliquée au démarrage se situe entre 130 et 140. Par exemple, lors d'une série de mise sous tension, le système d'asservissement a commandé le ventilateur avec les valeurs suivantes :
170, 138, 127, 136, 132, 135

A un moment donné, ces données deviennent optimales (étape 5.9), le récepteur les transmet alors au serveur 20 (étape 5.10). Le serveur 20 les enregistre dans sa mémoire 3.3. Dans le cas des paramètres d'allumage du ventilateur, les paramètres d'utilisation sont élaborés en fonction de la température. De ce fait, les paramètres précédemment listés sont accompagnés de la valeur de température mesurée. Si le récepteur 1 doit être posé sur d'autres appareils, il est déjà chaud lors de la mise sous tension, alors qu'isolé dans une pièce froide, sa température est moins élevée, et la consigne à appliquer est différente. Avantageusement, le serveur 20 mémorise un tableau de paramètres d'utilisation, en fonction d'une variable déduite par le récepteur 1, la température en l'occurrence. En fonction de la variable, le serveur extrait du tableau les paramètres d'utilisation correspondants. Si un autre récepteur émet une requête de téléchargement de paramètres d'utilisation, le serveur 20 lui envoie les paramètres que le premier récepteur 1 lui a transmis précédemment. Ainsi, les autres récepteurs peuvent au cours de leurs premières mises sous tension bénéficier de l'expérience acquise par un autre récepteur identique, dans les mêmes conditions d'utilisation. Avantageusement, le serveur qui a reçu un certain nombre de données provenant d'une population de récepteurs, sélectionne les valeurs minimum et maximum de certains paramètres et les envoie aux récepteurs qui en font la demande. Selon la contrainte de sécurité d'un récepteur, ce dernier peut utiliser la valeur au milieu de l'intervalle, ou la valeur minimale ou la valeur maximale.

Le moment déterminé pour transmettre des paramètres d'utilisation intervient lorsque ces paramètres ne varient plus, ou lorsque leurs variations d'une mise en marche à la mise en marche suivante sont inférieures à un seuil déterminé, typiquement lorsque la variation est inférieure à 5%. Pour déterminer ce moment, le système d'asservissement compare les écarts entre les nouveaux paramètres élaborés par rapport aux paramètres utilisés pour la dernière mise sous tension. En cas de quasi égalité, le récepteur 1 télécharge via le réseau numérique 6 les derniers paramètres élaborés. Une variante de détermination du moment de téléchargement des paramètres consiste à transmettre les paramètres d'utilisation au bout d'un nombre déterminé de mises sous tension. L'expérience a montré qu'au bout de dix mises sous tension, les paramètres d'allumage du ventilateur ne varient quasiment plus. Ce nombre de 10 est inscrit dans le système d'asservissement et est commun à tous les récepteurs d'un même type.

Un perfectionnement consiste en ce que le récepteur transmet son type et son modèle en même temps que ses paramètres d'utilisation. De cette façon, le serveur mémorise dans un tableau les paramètres en fonction du modèle et du type d'appareil émetteur desdits paramètres. Lorsque le serveur 20 reçoit une demande de paramètres d'un autre appareil, celui-ci transmet son modèle et son type et ainsi il reçoit des paramètres parfaitement adaptés, car élaborés par un appareil identique. Par exemple, l'appareil émetteur transmet avec les paramètres d'utilisation, son identifiant de type et de modèle « THOMSON DCI 1000 - V1 ».

La valeur de consigne et les coefficients K_{P}, K_{D} et K_{I} sont des exemples de paramètres d'utilisation. Il existe d'autres exemples de paramètres produits par une étape d'auto apprentissage. Les tailles des différentes mémoires de travail du récepteur 1 sont un autre exemple de paramètres. Dans un récepteur audiovisuel, un décodeur par exemple, la mémoire de travail est divisée en un certain nombre de zones telles que :
- mémoire dynamique de réception des données,
- mémoire dynamique de décryptage,
- zone allouée aux informations de service.

Ces différentes zones ont une taille par défaut définie en laboratoire. Par la suite, le système d'exploitation modifie la taille de ces zones en fonction de l'utilisation qui en ait faite. Par exemple, si au bout de cent heures de fonctionnement, la zone allouée aux informations de service est saturée alors que le tampon de réception n'est utilisé qu'à moitié, le système modifie les pointeurs délimitant la mémoire pour accroître la taille de la zone allouée aux informations de service. Ce type de paramètres d'utilisation est préférentiellement transmis au bout d'une certaine durée d'utilisation, au moins cent heures.

Selon un perfectionnement, et dans le cas de certains paramètres d'utilisation, lorsque le serveur a reçu plusieurs valeurs de paramètres provenant de différents récepteurs, il effectue une moyenne sur certains de ces paramètres. C'est particulièrement efficace pour les jeux de coefficients K_{P}, K_{D} et K_{I} du système d'asservissement. Typiquement, dans le cas du paramètre spécifiant la taille de la mémoire de travail allouée à certaines tâches, il est préférable de moyenner les différentes valeurs afin que globalement elles conviennent à un maximum de récepteurs.

Selon un autre perfectionnement éventuellement combinable au précédent, le serveur 20 modifie la valeur du paramètre reçu selon un rapport déterminé, afin d'accorder une marge de sécurité, typiquement 10%. Dans le cas du démarrage du ventilateur, pour être sûr que celui-ci démarre, le serveur augmente de 10% la valeur de consigne. Par exemple, si un récepteur 1 a transmis la valeur 100 sur 255 au serveur comme paramètre de consigne, le serveur envoie 110/255 aux récepteurs qui font une demande de paramètres d'utilisation. Cette marge permet de palier à la dispersion de caractéristiques mécaniques d'un ventilateur à l'autre.

Selon un autre perfectionnement, le serveur choisit soit la valeur minimale parmi toutes les valeurs transmises, soit la valeur maximale.

Selon un autre perfectionnement, le serveur 20 diffuse les paramètres d'utilisation sur le réseau de diffusion. Les paramètres sont alors encapsulés dans des paquets de données avec un en-tête spécifique. Ce perfectionnement limite les communications point par point avec le serveur 20. La diffusion des paramètres s'effectue en carrousel. Typiquement, ces paramètres sont diffusés en boucle de façon répétitive, par exemple toutes les 5 minutes. Dès qu'un récepteur 1 a transmis ses paramètres d'utilisation au serveur, celui-ci l'envoie sur le réseau de diffusion. Si un programme à besoin d'un ou de plusieurs données d'utilisation et si ce programme est téléchargé dans les différents récepteurs par le réseau de diffusion, alors le diffuseur peut directement mettre à jour le programme avec les dernières données d'utilisations transmises. Pour cela, juste avant sa diffusion, le diffuseur remplace les valeurs par défaut par celles transmises par les récepteurs ayant déjà effectué des étapes d'auto apprentissage.

Le fait qu'un récepteur ait bénéficié de la réception de paramètres d'utilisation, ne l'empêche pas de tester constamment son fonctionnement. Si après un certain temps d'utilisation, ou après un certain nombre d'utilisations, les valeurs des paramètres évoluent au-delà d'une certaines proportion, ils sont de nouveau téléchargés vers le serveur 20, en indiquant que c'est un second téléchargement. Ces secondes valeurs sont prises en compte par le serveur pour établir la marge de sécurité associée aux premières valeurs transmises. Il peut exister dans un parc donné de récepteurs des disparités entraînant des différences importantes de valeurs. De ce fait, la solution consistant à moyenner les valeurs reçues au niveau du serveur avant de les diffuser à d'autres récepteurs est particulièrement avantageuse.

Des personnes versées dans l'art pourront adapter la présente invention sous de nombreuses autres formes spécifiques sans l'éloigner du domaine d'application de l'invention comme revendiqué. En particulier, le module d'apprentissage peut déterminer les valeurs de toute grandeur physique utilisée dans tout type d'appareil électronique. Par conséquent, les présents modes de réalisation doivent être considérés à titre d'illustration mais peuvent être modifiés dans le domaine défini par la portée des revendications jointes.

## Revendications

1. Procédé de téléchargement de paramètres d'utilisation, le procédé comporte une étape d'auto apprentissage (4.1) exécutée lors d'une pluralité de mises en marche en vue d'élaborer de nouveaux paramètres d'utilisation à partir de premiers paramètres d'utilisation utilisés lors de la première mise sous tension d'un premier appareil, l'étape d'auto apprentissage (4.1) étant exécutée au niveau du premier appareil ; le procédé est **caractérisé en ce qu'**il comporte en outre :
- à l'issue de la pluralité de mises en marche permettant d'élaborer de nouveaux paramètres d'utilisation et lorsque leur variation d'une mise en marche à la mise en marche suivante est inférieure à un ratio déterminé, une étape de transmission (4.2) des nouveaux paramètres d'utilisation du premier appareil vers un au moins un second appareil,
- une étape d'utilisation (4.3) des nouveaux paramètres d'utilisation téléchargés dans le second appareil en remplacement de ceux en cours d'élaboration lors d'une étape d'auto apprentissage exécutée au niveau dudit second appareil.

2. Procédé de téléchargement de paramètres d'utilisation selon la revendication 1 **caractérisé en ce qu'**il comporte une étape d'émission des paramètres (5.10) du premier appareil vers un serveur (20) mémorisant lesdits paramètres et une étape de transmission (5.6) desdits paramètres du serveur (20) vers au moins le second appareil.

3. Procédé de téléchargement de paramètres d'utilisation selon la revendication 2, **caractérisé en ce qu'**il comporte entre la réception des paramètres provenant de premiers appareils et la transmission des paramètres mémorisés vers au moins le second appareil, une étape de modification de la valeur d'un ou plusieurs paramètres, consistant à effectuer la moyenne des valeurs reçues.

4. Procédé de téléchargement de paramètres d'utilisation selon la revendication 3 **caractérisé en ce qu'**il comporte entre la réception des paramètres provenant de premiers appareils et la transmission des paramètres mémorisés vers au moins le second appareil, une étape de modification de la valeur d'un ou plusieurs paramètres, consistant à rajouter une valeur déterminée aux valeurs reçues.

5. Procédé de téléchargement de paramètres d'utilisation selon l'une quelconque des revendications 2, 3 ou 4 **caractérisé en ce qu'**il comporte une étape de diffusion sur un réseau unidirectionnel des paramètres provenant d'un premier appareil, modifiés ou non, de façon répétitive.

6. Appareil électronique (1) comportant un moyen d'élaboration (3,12) de nouveaux paramètres d'utilisation au cours d'un auto apprentissage, les nouveaux paramètres d'utilisation étant élaborés à partir de premiers paramètres d'utilisation utilisés lors de la première mise sous tension dudit l'appareil, **caractérisé en ce que** lesdits nouveaux paramètres sont définis à l'issue d'une pluralité de mises en marche et **en ce que** l'appareil comporte un moyen de transmission (5) vers un serveur desdits nouveaux paramètres d'utilisation lorsque la variation des paramètres d'une mise en marche à la mise en marche suivante est inférieure à un ratio déterminé.

## Claims

1. Method of downloading usage parameters, the method comprising a self-learning step (4.1) executed over a plurality of start-ups in order to generate new usage parameters based on first usage parameters used over the first switch-on of said first apparatus, the self-learning step (4.1) being executed on the first apparatus; the method is **characterized in that** it also comprises:
- after the plurality of start-ups for generating new usage parameters and when their variation between one switch-on and the next switch-on is less than a determined ratio, a step (4.2) for transmitting new usage parameters from the first apparatus to at least one second apparatus,
- a step (4.3) for using the new usage parameters downloaded into the second apparatus, replacing those being generated in a self-learning step executed on said second apparatus.

2. Method of downloading usage parameters according to claim 1, **characterized in that** it comprises a step (5.10) for sending the parameters from the first apparatus to a server (20) storing said parameters and a step (5.6) for transmitting said parameters from the server (20) to at least the second apparatus.

3. Method of downloading usage parameters according to Claim 2, **characterized in that** it comprises, between the reception of the parameters originating from first apparatuses and the transmission of the stored parameters to at least the second apparatus, a step for modifying the value of one or more parameters, consisting in calculating the average of the received values.

4. Method of downloading usage parameters according to Claim 3, **characterized in that** it comprises, between the reception of the parameters originating from first apparatuses and the transmission of the stored parameters to at least the second apparatus, a step for modifying the value of one or more parameters, consisting in adding a determined value to the received values.

5. Method of downloading usage parameters according to any one of Claims 2, 3 or 4, **characterized in that** it comprises a step for repetitively transmitting over a unidirectional network the parameters originating from a first apparatus, modified or not.

6. Electronic apparatus (1) comprising a means (3, 12) of generating new usage parameters during a self-learning step, said new usage parameters being elaborated based on first usage parameters used over the first switch-on of said apparatus, **characterized in that** said new parameters are defined after a plurality of start-ups and **in that** the apparatus comprises a means (5) of transmitting said new usage parameters to a server when the variation of the parameters between one switch-on and the next switch-on is less than a determined ratio.

## Patentansprüche

1. Verfahren zum Herunterladen von Benutzungsparametern, wobei das Verfahren einen Selbstlernschritt (4.1) umfasst, der während einer Vielzahl von Einschaltungen durchgeführt wird, um neue Benutzungsparametern aus ersten Benutzungsparametern zu erarbeiten, die während der ersten Unterspannungssetzung eines ersten Geräts verwendet werden, wobei der Selbstlernschritt (4.1) an dem ersten Gerät durchgeführt wird, **dadurch gekennzeichnet, dass** es ferner folgende Schritte umfasst:
- am Ende der Vielzahl von Einschaltungen, welche die Erarbeitung neuer Benutzungsparameter ermöglichen, und wenn deren Änderung von einer Einschaltung zur nächsten geringer ist als ein bestimmtes Verhältnis, einen Schritt der Übermittlung (4.2) der neuen Benutzungsparameter von dem ersten Gerät an mindestens ein zweites Gerät,
- einen Schritt der Verwendung (4.3) der neuen heruntergeladenen Benutzungsparameter in dem zweiten Gerät ersatzweise für diejenigen, die während eines an dem zweiten Gerät durchgeführten Selbstlernschritts gerade in Erarbeitung begriffen sind.

2. Verfahren zum Herunterladen von Benutzungsparametern nach Anspruch 1, **dadurch gekennzeichnet, dass** es einen Schritt des Sendens der Parameter (5.10) von dem ersten Gerät zu einem Server (20), der die Parameter speichert, und einen Schritt der Übermittlung (5.6) der Parameter von dem Server (20) an mindestens das zweite Gerät umfasst.

3. Verfahren zum Herunterladen von Benutzungsparametern nach Anspruch 1, **dadurch gekennzeichnet, dass** es zwischen dem Empfang der Parameter aus ersten Geräten und der Übermittlung der gespeicherten Parameter an mindestens das zweite Gerät einen Schritt der Änderung des Werts eines oder mehrerer Parameter umfasst, der darin besteht, die empfangenen Werte zu mitteln.

4. Verfahren zum Herunterladen von Benutzungsparametern nach Anspruch 3, **dadurch gekennzeichnet, dass** es zwischen dem Empfang der Parameter aus ersten Geräten und der Übermittlung der gespeicherten Parameter an mindestens das zweite Gerät einen Schritt der Änderung des Werts eines oder mehrerer Parameter umfasst, der darin besteht, den empfangenen Werten einen bestimmten Wert hinzuzufügen.

5. Verfahren zum Herunterladen von Benutzungsparametern nach einem beliebigen der Ansprüche 2, 3 oder 4, **dadurch gekennzeichnet, dass** es einen Schritt der wiederholten Verbreitung über ein unidirektionales Netz der geänderten oder nicht geänderten Parameter aus einem ersten Gerät umfasst.

6. Elektronisches Gerät (1) mit einem Mittel für die Erarbeitung (3, 12) von neuen Benutzungsparametern während eines Selbstlernens, wobei die neuen Benutzungsparameter aus ersten Benutzungsparameter erarbeitet werden, die während der ersten Unterspannungssetzung des Geräts verwendet werden, **dadurch gekennzeichnet, dass** die neuen Parameter am Ende einer Vielzahl von Einschaltungen bestimmt werden und dass das Gerät ein Mittel aufweist für die Übermittlung (5) der neuen Benutzungsparameter an einen Server, wenn die Änderung der Parameter von einer Einschaltung zur nächsten geringer ist als ein bestimmtes Verhältnis.
